# FASCICULE DE BREVET EUROPEEN

(11) **EP 4 413 651 B1**
(45) Date de publication et mention de la délivrance du brevet: **30.07.2025**
(21) Numéro de dépôt: 22793552.5
(22) Date de dépôt: 28.09.2022
(51) Int. Cl.: H02K 11/33, H02K 9/19, H02M 1/32, H02M 7/00, H01L 23/473

(54) **CONVERTISSEUR ÉLECTRIQUE CONFIGURÉ POUR ALIMENTER UNE MACHINE ÉLECTRIQUE, MODULE ÉLECTRIQUE COMPORTANT UN TEL CONVERTISSEUR, PROCÉDÉ D'UTILISATION D'UN TEL MODULE ÉLECTRIQUE**
ELEKTRISCHER UMWANDLER ZUR VERSORGUNG EINER ELEKTRISCHEN MASCHINE, ELEKTRISCHES MODUL MIT EINEM SOLCHEN UMWANDLER, VERFAHREN ZUR VERWENDUNG EINES SOLCHEN ELEKTRISCHEN MODULS
ELECTRIC CONVERTER CONFIGURED TO SUPPLY AN ELECTRIC MACHINE, ELECTRIC MODULE COMPRISING SUCH A CONVERTER, METHOD OF USING SUCH AN ELECTRIC MODULE

(30) Priorité: 06.10.2021 FR 2110609
(43) Date de publication de la demande: 14.08.2024
(73) Titulaire: Safran Electrical & Power, 31702 Blagnac (FR)
(72) Inventeur: CHAPERON, Vincent, 77550 MOISSY-CRAMAYEL (FR); NEHME, Samir, 77550 MOISSY-CRAMAYEL (FR); GONCALVES, Rémi, 77550 MOISSY-CRAMAYEL (FR); M'FUMU AMBIL, Raïs, 77550 MOISSY-CRAMAYEL (FR); THIAM, Abdoulahad, 77550 MOISSY-CRAMAYEL (FR)
(74) Mandataire: Argyma
(86) Numéro de dépôt international: PCT/EP2022/076915
(87) Numéro de publication internationale: WO 2023/057269

(56) Documents cités:
- FR-A1- 2 895 845
- US-A1- 2005 180 104
- US-A1- 2019 181 717

## Description

### Domaine technique

La présente invention concerne le domaine du refroidissement d'un convertisseur électrique alimentant une machine électrique, en particulier, un moteur électrique d'un aéronef participant à la propulsion dudit aéronef.

De manière connue, un moteur électrique peut être associé à un convertisseur électrique de manière à fournir de l'énergie mécanique à partir d'une source de tension continue, par exemple, une batterie électrique. En pratique, le convertisseur électrique permet de convertir la tension continue en une tension alternative, en particulier triphasée. Pour permettre la conversion électrique, le convertisseur électrique comporte plusieurs onduleurs de puissance ayant chacun trois modules de puissance, c'est-à-dire, un par branche d'onduleur pour un onduleur triphasé.

Afin de limiter l'encombrement et de réduire la longueur de câblage, il a été proposé d'associer le moteur électrique et son convertisseur dans un même module électrique, c'est-à-dire, dans un même ensemble. En pratique, le module électrique est installé dans des environnements thermiques et vibratoires qui sont sévères et qui augmentent le risque de pannes. Pour limiter ce risque, il est connu de prévoir des redondances afin d'assurer une continuité de service. Une solution immédiate de redondance serait de prévoir deux modules électriques distincts mais cela pénalise l'encombrement et la masse de manière trop importante. Aussi, il a été proposé de fournir un convertisseur électrique comportant deux canaux fonctionnels indépendants. Autrement dit, le convertisseur électrique est partagé entre deux canaux fonctionnels qui peuvent fonctionner de manière individuelle ou de manière collective. A cet effet, un convertisseur peut comprendre un grand nombre de modules de puissance en fonction de la puissance désirée.

Afin de former un module électrique compact, il a été proposé un convertisseur de forme annulaire de manière à définir intérieurement un passage longitudinal dans lequel peut être monté un arbre du moteur électrique. A cet effet, le moteur électrique s'étend longitudinalement et comporte un stator annulaire à l'intérieur duquel est monté un rotor relié à l'arbre moteur. Les modules de puissance sont organisés de manière annulaire dans le convertisseur afin d'être connectés directement au stator annulaire du moteur électrique pour diminuer la longueur des connexions électriques, et par voie de conséquence, le risque de dysfonctionnement.

Afin d'être refroidis de manière optimale, les modules de puissance sont positionnés à la périphérie extérieure du convertisseur électrique de manière à maximiser les échanges thermiques avec l'extérieur du module électrique. Néanmoins, du fait des contraintes de redondance, le nombre de modules de puissance est important et les besoins en refroidissement sont très élevés.

Pour loger de nombreux modules de puissance, une solution immédiate serait d'augmenter la surface extérieure en augmentant le diamètre ou la longueur du convertisseur électrique mais cela va à l'encontre des objectifs de réduction de l'encombrement et de la masse.

L'invention vise ainsi à éliminer au moins certains de ces inconvénients en proposant un convertisseur électrique ayant un refroidissement amélioré qui permette une redondance élevée et limite la longueur des connexions.

On connaît dans l'art antérieur par les demandes de brevet US201901817171A1, US20050180104A1 et FR2895845A des systèmes de refroidissement selon l'art antérieur.

### PRESENTATION DE L'INVENTION

L'invention concerne un convertisseur électrique configuré pour alimenter une machine électrique, en particulier pour aéronef, comportant un stator annulaire et un rotor, le convertisseur électrique comprenant :
- une pluralité d'onduleurs de puissance comprenant chacun une pluralité de dispositifs de puissance configurés pour être reliés au stator annulaire de manière à alimenter la machine électrique,
- un carter, de forme annulaire, s'étendant longitudinalement selon un axe X et définissant une surface radialement intérieure et une surface radialement extérieure, le carter comportant une pluralité de baignoires de refroidissement formées dans la surface radialement intérieure, appelées baignoires intérieures, et dans la surface radialement extérieure, appelées baignoires extérieures,
- un circuit de refroidissement configuré pour alimenter chaque baignoire intérieure et chaque baignoire extérieure en fluide de refroidissement, et
- les dispositifs de puissance étant montés dans les baignoires intérieures et les baignoires extérieures de manière à permettre un refroidissement de l'ensemble des dispositifs de puissance.

Grâce à l'invention, les dispositifs sont écartés les uns les autres et disposés selon un anneau intérieur et un anneau extérieur, ce qui limite la formation de zones chaudes. La présence de baignoires intérieures et de baignoires extérieures permet de refroidir de manière individuelle et homogène chaque baignoire avec du fluide de refroidissement. Ainsi, un convertisseur électrique avec un grand nombre de dispositifs de puissance peut être refroidi de manière optimale tout en conservant des dimensions réduites.

De manière préférée, les baignoires intérieures et/ou les baignoires extérieures ont la même position longitudinale. Ainsi, les dispositifs de puissance peuvent être reliés au stator annulaire par des câbles courts de même longueur, ce qui limite le risque de défaut électrique.

Selon un aspect, le convertisseur électrique comporte autant de baignoires intérieures que de baignoires extérieures. De manière préférée, les baignoires intérieures et les baignoires extérieures sont alternées à la périphérie du carter. De manière préférée, les baignoires intérieures et les baignoires extérieures sont réparties angulairement à la périphérie du carter. Cela permet de répartir au mieux les dispositifs de puissance pour éviter un échauffement local.

Selon un aspect de l'invention, le circuit de refroidissement comprend une entrée et une sortie qui sont diamétralement opposées et reliées par au moins deux branches de refroidissement indépendantes, de préférence, diamétralement opposées. Cela permet de réduire le débit ainsi que les pertes de charge.

De manière préférée, le circuit de refroidissement comporte des canaux s'étendant dans l'épaisseur du carter et reliant les baignoires intérieures et les baignoires extérieures. Ainsi, le circuit de refroidissement est intégré au carter, ce qui limite l'encombrement du carter et permet d'utiliser le corps du carter pour dissiper la chaleur des dispositifs de puissance.

De préférence, deux baignoires adjacentes sont reliées par une pluralité de canaux indépendants, de préférence, plus de 10. Cela permet de réduire de manière importante les pertes de charge.

De préférence, au moins un dispositif de puissance comporte un module de puissance associé à un radiateur de dissipation, le radiateur de dissipation étant monté dans une baignoire intérieure ou une baignoire extérieure. L'utilisation d'un radiateur de dissipation permet de capter les calories du module de puissance de manière à les évacuer de manière optimale avec le fluide de refroidissement des baignoires.

De manière préférée, le radiateur de dissipation comporte des ailettes positionnées dans la baignoire intérieure ou dans la baignoire extérieure afin d'augmenter la surface d'échange et optimiser le transfert de calories.

De préférence, le dispositif de puissance comporte des organes de verrouillage configurés pour coopérer avec des organes de réception formés dans le carter de manière à maintenir le radiateur de dissipation dans la baignoire intérieure ou la baignoire extérieure. De préférence, les organes de verrouillage permettent un montage amovible.

L'invention concerne également un module électrique comportant une machine électrique, en particulier pour aéronef, comprenant un stator annulaire et un rotor, et un convertisseur électrique, tel que présenté précédemment, dont les dispositifs de puissance sont reliés au stator annulaire de manière à alimenter la machine électrique. De manière préférée, le stator annulaire possède sensiblement le même diamètre que le carter du convertisseur électrique de manière à réaliser des connexions électriques de faible longueur.

De manière préférée, le convertisseur électrique est alimenté par une source de tension continue.

Selon un premier aspect, le convertisseur électrique comportant un circuit de refroidissement, désigné ci-après premier circuit de refroidissement, la machine électrique comportant un circuit de refroidissement, désigné ci-après deuxième circuit de refroidissement, le premier circuit de refroidissement et le deuxième circuit de refroidissement sont alimentés en série en fluide de refroidissement. On tire avantageusement partie des faibles pertes de charge pour associer les deux circuits de refroidissement et ainsi gagner en compacité.

Selon un deuxième aspect, le convertisseur électrique comportant un circuit de refroidissement, désigné ci-après premier circuit de refroidissement, la machine électrique comportant un circuit de refroidissement, désigné ci-après deuxième circuit de refroidissement, le premier circuit de refroidissement et le deuxième circuit de refroidissement sont alimentés en parallèle en fluide de refroidissement.

L'invention concerne également un procédé d'utilisation d'un module électrique, tel que présenté précédemment, comprenant des étapes consistant à :
- Alimenter la machine électrique par les dispositifs de puissance du convertisseur électrique,
- Faire circuler un fluide de refroidissement dans le circuit de refroidissement du convertisseur électrique de manière à refroidir lesdits dispositifs de puissance.

### PRESENTATION DES FIGURES

L'invention sera mieux comprise à la lecture de la description qui va suivre, donnée à titre d'exemple, et se référant aux figures suivantes, données à titre d'exemples non limitatifs, dans lesquelles des références identiques sont données à des objets semblables.
La [Fig.1] est une représentation schématique d'un module électrique selon une forme de réalisation de l'invention.
La [Fig.2] est une représentation schématique en coupe d'une machine électrique du module électrique de la [Fig.1].
La [Fig.3] est une représentation schématique d'un convertisseur électrique relié à un stator de la machine électrique.
La [Fig.4] est une représentation schématique en perspective d'un convertisseur électrique selon une forme de réalisation selon l'invention.
La [Fig.5] est une représentation schématique en coupe transversale d'un convertisseur électrique avec un circuit de refroidissement à deux branches.
La [Fig.6] est une représentation schématique d'une baignoire extérieure du convertisseur de la [Fig.4] sans dispositif de puissance.
La [Fig.7] est une représentation schématique d'une étape de montage d'un dispositif de puissance dans la baignoire extérieure de la [Fig.6].
La [Fig.8] est une représentation schématique de côté d'un dispositif de puissance et d'une baignoire extérieure.
La [Fig.9] est une représentation schématique d'un dispositif de puissance monté dans une baignoire extérieure de la [Fig.6].
La [Fig.10] est une représentation schématique d'une première forme de réalisation d'un circuit de refroidissement dans le module électrique.
La [Fig.11] est une représentation schématique d'une deuxième forme de réalisation d'un circuit de refroidissement dans le module électrique.
La [Fig.12] est une représentation schématique d'une troisième forme de réalisation d'un circuit de refroidissement dans le module électrique.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

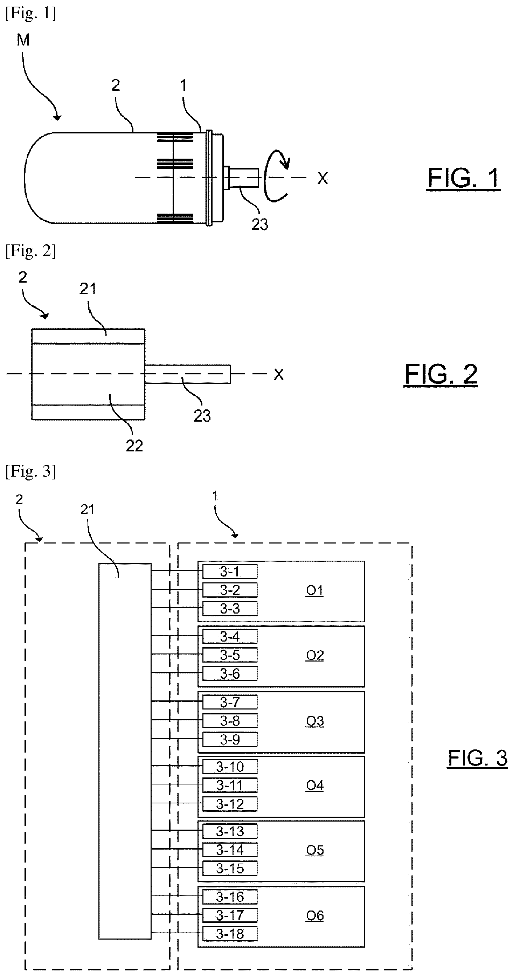

En référence à la [Fig.1], l'invention concerne un module électrique M, en particulier pour aéronef, comportant une machine électrique 2 et un convertisseur électrique 1 pour alimenter la machine électrique 2.

Comme illustré à la [Fig.2], la machine électrique 2 comporte un stator annulaire 21 à l'intérieur duquel est monté un rotor 22 s'étendant selon un axe longitudinal X. Dans cet exemple, le stator annulaire 21 définit une pluralité d'étoiles électriques, à trois branches, qui sont alimentées par le convertisseur électrique 1 de manière à pouvoir entrainer le rotor 22. Par la suite, il va être présenté une machine électrique 2 fonctionnant en tant que moteur mais il va de soi qu'elle pourrait aussi fonctionner comme un générateur. Dans cet exemple, comme illustré aux figures 1 et 2, le rotor 22 comporte un arbre de rotor 23 qui s'étend en saillie longitudinalement selon l'axe X. La machine électrique 2 comporte de préférence un circuit de refroidissement. La structure générale d'une telle machine électrique 2 est connue et ne sera pas présentée plus en détails.

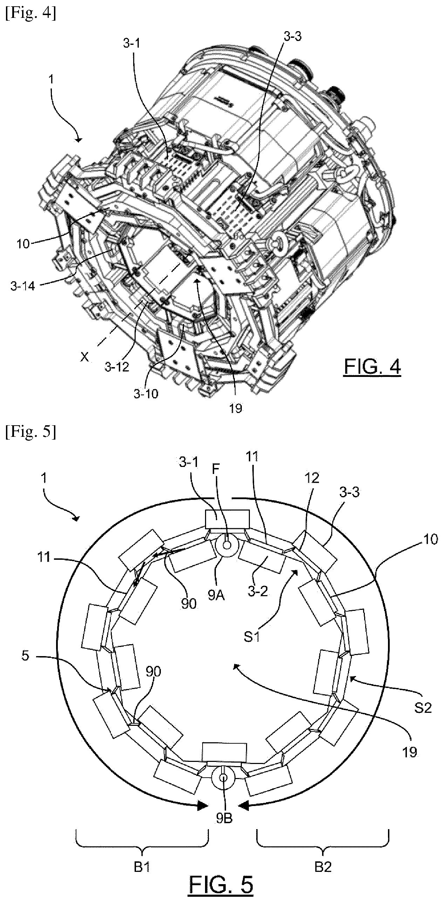

En référence à la [Fig.5], le convertisseur électrique 1 comprend un carter 10, de forme annulaire, s'étendant longitudinalement selon l'axe X et définissant une surface radialement intérieure S1 et une surface radialement extérieure S2. De manière préférée, le carter 10 possède un diamètre sensiblement égal au diamètre du stator annulaire 21 de la machine électrique 2 de manière à permettre une connexion électrique directe avec le stator annulaire 21 comme cela sera présenté par la suite. Le carter 10 définit une ouverture centrale 19 dans laquelle peut être introduit l'arbre de rotor 23. De manière préférée, l'arbre de rotor 23 peut être associé, par exemple, à un actionneur de pas d'hélice d'un aéronef du type VTOL ou STOL.

Comme illustré schématiquement à la [Fig.3], le convertisseur électrique 1 comporte en outre une pluralité d'onduleurs de puissance O1-O6 comprenant chacun une pluralité de dispositifs de puissance 3-1 ; 3-18 configurés pour être reliés au stator annulaire 21 de la machine électrique 2 afin d'assurer une redondance. Chaque onduleur O1-O6 est triphasé et est associé à trois dispositifs de puissance 3-1 ; 3-18. Aussi, comme illustré à la [Fig.3], le convertisseur électrique 1 comporte 18 dispositifs de puissance 3-1 ; 3-18 qui sont alimentés par une ou plusieurs sources de tension (non représentées) afin de pouvoir alimenter le stator annulaire 21 et entrainer en rotation le rotor 22.

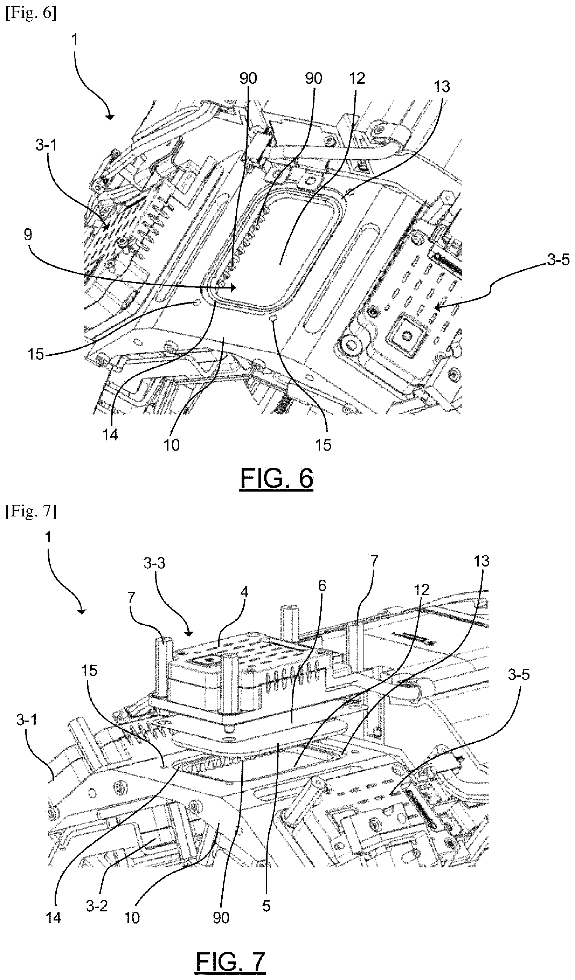

Selon l'invention, en référence aux figures 5 et 6, le carter 10 comporte une pluralité de baignoires de refroidissement formées dans la surface radialement intérieure S1, appelées baignoires intérieures 11, et dans la surface radialement extérieure S2, appelées baignoires extérieures 12. Le convertisseur électrique 1 comporte en outre un circuit de refroidissement 9 configuré pour alimenter chaque baignoire intérieure 11 et chaque baignoire extérieure 12 en fluide de refroidissement F, en particulier, avec de l'huile ou analogue. Les dispositifs de puissance 3-1 ; 3-18 sont montés dans les baignoires intérieures 11 et dans les baignoires extérieures 12 de manière à permettre un refroidissement de l'ensemble des dispositifs de puissance 3-1 ; 3-18.

Grâce à l'invention, le convertisseur électrique 1 peut être connecté de manière pratique à la machine électrique 2 avec des connexions courtes tout en permettant un refroidissement optimal des dispositifs de puissance 3-1 ; 3-18 qui sont avantageusement répartis sur la surface intérieure S1 et la surface extérieure S2 du carter 10. Ainsi, on tire avantage de la forme annulaire du convertisseur électrique 1 pour exploiter de manière optimale la surface disponible. Les différents éléments du convertisseur électrique 1 vont être dorénavant présentés de manière détaillée.

Dans cet exemple, le carter 10 comporte des baignoires intérieures 11 et des baignoires extérieures 12 qui sont formées dans l'épaisseur du carter 10. Autrement dit, les baignoires 11, 12 sont des cavités directement formées dans le carter 10 du convertisseur électrique 1 afin de limiter l'encombrement et améliorer le refroidissement. De manière préférée, le carter 10 est réalisé dans un matériau métallique.

Comme illustré à la [Fig.6], chaque baignoire intérieure 11 ou extérieure 12 possède une forme sensiblement rectangulaire afin de correspondre à celle d'un dispositif de puissance 3-1 ; 3-18 mais il va de soi qu'elle pourrait être de forme différente. La profondeur d'une baignoire 11, 12, définie selon la direction radiale par rapport à l'axe longitudinal X, est fonction du dispositif de puissance 3-1 ; 3-18.

Les baignoires intérieures 11 et les baignoires extérieures 12 sont de préférence formées à une extrémité longitudinale du carter 10 du convertisseur électrique 1, celle destinée à être connectée à la machine électrique 2. De manière préférée, les baignoires intérieures 11 et les baignoires extérieures 12 sont à la même position longitudinale, définie selon l'axe X. Ainsi, les dispositifs de puissance 3-1 ; 3-18 peuvent être raccordés par des connexions de même longueur au stator annulaire 21, ce qui limite le risque de défaillance.

Le nombre de baignoires intérieures 11 et de baignoires extérieures 12 est fonction du nombre de dispositifs de puissance 3-1 ; 3-18 à refroidir. Dans cet exemple, en référence à la [Fig.5], le convertisseur électrique 10 comporte autant de baignoires intérieures 11 que de baignoires extérieures 12. De préférence, les baignoires intérieures 11 et les baignoires extérieures 12 sont alternées à la périphérie du carter 10, en particulier, les baignoires intérieures 11 et les baignoires extérieures 12 sont réparties angulairement à la périphérie du carter 10, ce qui permet de bénéficier d'une répartition optimale de la chaleur comme illustré à la [Fig.5].

Dans cet exemple, les dispositifs de puissance 3-1 ; 3-18 possèdent la même position longitudinale mais sont séparés en deux groupes ayant deux positions radiales différentes (anneau intérieur et anneau extérieur). Il va de soi que les positions longitudinales pourraient être différentes.

Comme indiqué précédemment, en référence à la [Fig.5], le convertisseur électrique 1 comporte un circuit de refroidissement 9 configuré pour alimenter chaque baignoire intérieure 11 et chaque baignoire extérieure 12 en fluide de refroidissement F, en particulier, de l'huile.

Dans cet exemple, toujours en référence à la [Fig.5], le circuit de refroidissement 9 comprend une entrée 9A configurée pour alimenter le circuit de refroidissement 9 en fluide de refroidissement F et une sortie 9B pour évacuer le fluide de refroidissement F. De manière préférée, le circuit de refroidissement 9 comporte une unique entrée 9A et une unique sortie 9B mais il va de soi qu'elles pourraient être plus nombreuses.

Dans cet exemple, l'entrée 9A et la sortie 9B sont diamétralement opposées et reliées par deux branches de refroidissement indépendantes B1, B2, de préférence, diamétralement opposées. Les branches B1, B2 sont symétriques afin de refroidir de manière analogue tous les dispositifs de puissance 3-1 ; 3-18. L'utilisation de deux branches B1, B2 permet de réduire le débit et donc les pertes de charge par comparaison à une unique branche. Il va de soi qu'une unique branche pourrait néanmoins convenir.

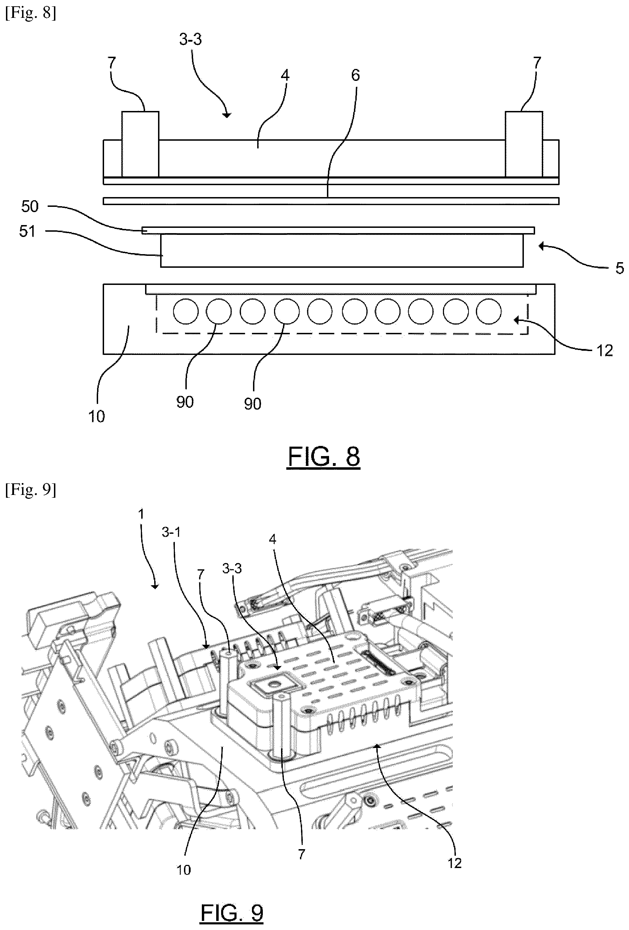

Le circuit de refroidissement 9 comporte des canaux 90 s'étendant dans l'épaisseur du carter 10 pour relier les baignoires intérieures 11 et les baignoires extérieures 12. De manière préférée, deux baignoires adjacentes, en particulier une baignoire intérieure 11 et une baignoire extérieure 12, sont reliées par une pluralité de canaux indépendants 90, de préférence parallèles. La section des canaux indépendants 90 est déterminée pour optimiser les pertes de charge et réduire le débit. Dans cet exemple, il est prévu 12 canaux indépendants entre chaque baignoire 11, 12. De préférence, les canaux indépendants 90 débouchent dans une paroi latérale d'une baignoire intérieure 11 ou d'une baignoire extérieure 12 comme illustré à la [Fig.6] et à la [Fig.8]. De préférence, chaque canal indépendant 90 s'étend dans un plan transversal à l'axe X de manière à permettre une circulation angulaire.

Dans cet exemple, en référence aux figures 6 à 9, les dispositifs de puissance 3-1 ; 3-18 sont identiques et il ne sera présenté en détails que le dispositif de puissance 3-3 monté dans une baignoire extérieure 12. Il va de soi que la description s'applique de manière analogue au montage d'un dispositif de dissipation dans une baignoire intérieure 11.

En référence aux figures 7 et 8, le dispositif de puissance 3-3 comporte un module de puissance 4, comprenant des composants électroniques, qui forme l'élément fonctionnel principal. Le module de puissance 4 comporte des connecteurs électriques et une enceinte apte à conduire la chaleur. Le dispositif de puissance 3-3 comporte un radiateur de dissipation 5 qui est configuré pour conduire et dissiper la chaleur générée par le module de puissance 4, en particulier, par conduction.

Le radiateur de dissipation 5 est positionné contre une face inférieure du module de puissance 4. Dans cet exemple, le dispositif de puissance 3-3 comporte une plaque de conduction 6 montée à l'interface entre le module de puissance 4 et le radiateur de dissipation 5 pour faciliter la dissipation thermique. Une telle plaque de conduction 6 est optionnelle.

Le radiateur de dissipation 5 comporte une plaque principale 50 depuis laquelle s'étendent plusieurs ailettes 51 en saillie configurées pour augmenter la surface d'échange et dissiper les calories reçues par la plaque principale 50 en contact avec la plaque de conduction 6. De manière préférée, en position montée, les ailettes 51 s'étendent dans la baignoire extérieure 12 de manière à ce que le fluide de refroidissement F prélève les calories à la surface des ailettes 51. De préférence, chaque ailette 51 s'étend orthogonalement à la plaque principale 50 et possède une section de forme carrée, appelée également « diamant ». La taille et la forme des ailettes 51 sont déterminées de manière à optimiser le refroidissement et la perte de charge du fluide de refroidissement F circulant dans chaque baignoire 11, 12. Ainsi, chaque radiateur de dissipation 5 est monté dans une baignoire intérieure 11 ou une baignoire extérieure 12 afin de baigner ses ailettes 51.

En référence à la [Fig.7], afin d'assurer une étanchéité optimale, la baignoire extérieure 12 comporte une empreinte 13 de forme complémentaire à celle de la plaque principale 50 du radiateur de dissipation 5 de manière à réaliser un emboitement par complémentarité de formes. L'empreinte 13 comporte en outre un joint d'étanchéité 14, de préférence périphérique, configuré pour être comprimé par la plaque principale 50 du radiateur de dissipation 5 en position montée.

De manière préférée, en référence à la [Fig.7], le dispositif de puissance 3-3 comporte en outre des organes de verrouillage 7 configurés pour coopérer avec des organes de réception 15 formés dans le carter 10 de manière à monter le dispositif de puissance 3-3 dans une baignoire extérieure 12, en particulier, son échangeur de dissipation 5. Dans cet exemple, le dispositif de puissance 3-3 comporte quatre organes de verrouillage 7, en particulier des vis, qui sont positionnés à chaque coin du pavé dont le dispositif de puissance 3-3 a la forme. Quatre organes de réception 15, par exemple des taraudages, sont formés dans le carter 10, extérieurement à la baignoire extérieure 12. En position montée comme illustré à la 9, lorsque les organes de verrouillage 7 coopèrent avec les organes de réception 15, ils assurent, d'une part, un maintien mécanique au carter 10 et, d'autre part, une compression du joint d'étanchéité 14. Les ailettes 51 sont baignées dans la baignoire extérieure 12 qui est fermée de manière étanche. Un tel dispositif de puissance 3-3 peut ainsi être monté de manière amovible, ce qui facilite la maintenance. Il va de soi que le radiateur de dissipation 5 pourrait être directement soudé au carter 10.

Pour assembler le module électrique M, les dispositifs de puissance 3-1 ;3-18 du convertisseur électrique 1 sont montés au carter 10 puis reliés électriquement aux étoiles électriques du stator annulaire 21 de la machine électrique 2 par des connexions courtes et directes, ce qui limite le risque de dysfonctionnement. Au cours de l'alimentation de la machine électrique 2 par le convertisseur électrique 1, du fluide de refroidissement F est introduit par l'entrée 9A afin d'alimenter le circuit de refroidissement 9 pour collecter les calories des ailettes 51 avant d'être évacué au niveau de la sortie 9B comme illustré à la [Fig.5]. Le fluide de refroidissement F circule successivement entre une alternance de baignoires intérieures 11 et de baignoires extérieures 12 reliées par des canaux indépendants 90 afin de refroidir chacun des dispositifs de puissance 3-1 ;3-18.

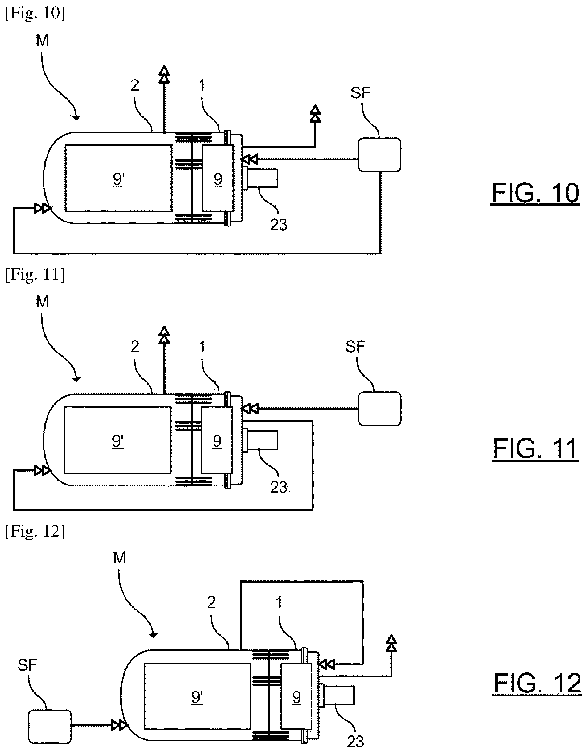

En référence aux figures 10 à 12, le convertisseur électrique 1 comporte un circuit de refroidissement 9, désigné ci-après premier circuit de refroidissement 9, tandis que la machine électrique 2 comporte un circuit de refroidissement, désigné ci-après deuxième circuit de refroidissement 9', pour refroidir notamment le stator annulaire 21 (voir [Fig.2]).

Afin d'optimiser le refroidissement du module électrique M, le premier circuit de refroidissement 9 et le deuxième circuit de refroidissement 9' peuvent être alimentés en parallèle en fluide de refroidissement F issu d'une source de fluide SF comme illustré à la [Fig.10].

De manière alternative, en référence aux figures 11 et 12, le premier circuit de refroidissement 9 et le deuxième circuit de refroidissement 9' sont alimentés en série en fluide de refroidissement F issu d'une source de fluide SF. Une telle solution est avantageusement envisageable étant donné que les pertes de charge sont faibles dans le premier circuit de refroidissement 9. Le premier circuit de refroidissement 9 peut être alimenté avant le deuxième circuit de refroidissement 9' comme représenté à la [Fig.11] ou après comme représenté à la [Fig.12]. La configuration de la [Fig.11] est avantageuse étant donné qu'elle permet de refroidir en premier le convertisseur électrique 1 qui a des besoins de refroidissement supérieurs. Ainsi, le premier circuit de refroidissement 9 et le deuxième circuit de refroidissement 9' forment ensemble un circuit de refroidissement global pour le module électrique M.

## Revendications

1. Convertisseur électrique (1) configuré pour alimenter une machine électrique (2), en particulier pour aéronef, comportant un stator annulaire (21) et un rotor (22), le convertisseur électrique (1) comprenant :
• une pluralité d'onduleurs de puissance (01-06) comprenant chacun une pluralité de dispositifs de puissance (3-1 ; 3-18) configurés pour être reliés au stator annulaire (21) de manière à alimenter la machine électrique (2),
• un carter (10), de forme annulaire, s'étendant longitudinalement selon un axe X et définissant une surface radialement intérieure (S1) et une surface radialement extérieure (S2), le carter (10) comportant une pluralité de baignoires de refroidissement formées dans la surface radialement intérieure (S1), appelées baignoires intérieures (11), et dans la surface radialement extérieure (S2), appelées baignoires extérieures (12),
• un circuit de refroidissement (9) configuré pour alimenter chaque baignoire intérieure (11) et chaque baignoire extérieure (12) en fluide de refroidissement (F), et
• les dispositifs de puissance (3-1 ; 3-18) étant montés dans les baignoires intérieures (11) et les baignoires extérieures (12) de manière à permettre un refroidissement de l'ensemble des dispositifs de puissance (3-1 ; 3-18).

2. Convertisseur électrique (1) selon la revendication 1, dans lequel les baignoires intérieures (1) et/ou les baignoires extérieures (12) ont la même position longitudinale.

3. Convertisseur électrique (1) selon l'une des revendications 1 et 2, dans lequel le convertisseur électrique (1) comporte autant de baignoires intérieures (11) que de baignoires extérieures (12).

4. Convertisseur électrique (1) selon l'une des revendications 1 à 3, dans lequel les baignoires intérieures (11) et les baignoires extérieures (12) sont alternées à la périphérie du carter (10).

5. Convertisseur électrique (1) selon l'une des revendications 1 à 4, dans lequel les baignoires intérieures (11) et les baignoires extérieures (12) sont réparties angulairement à la périphérie du carter (10).

6. Convertisseur électrique (1) selon l'une des revendications 1 à 5, dans lequel le circuit de refroidissement (9) comprend une entrée (9A) et une sortie (9B) qui sont diamétralement opposées et reliées par au moins deux branches de refroidissement indépendantes (B1, B2), de préférence, diamétralement opposées.

7. Convertisseur électrique (1) selon l'une des revendications 1 à 6, dans lequel le circuit de refroidissement (9) comporte des canaux (90) s'étendant dans l'épaisseur du carter (10) et reliant les baignoires intérieures (11) et les baignoires extérieures (12).

8. Convertisseur électrique (1) selon la revendication 7, dans lequel deux baignoires adjacentes (11, 12) sont reliées par une pluralité de canaux indépendants (90), de préférence, plus de 10.

9. Convertisseur électrique (1) selon l'une des revendications 1 à 8, dans lequel au moins un dispositif de puissance (3-1 ;3-18) comporte un module de puissance (4) associé à un radiateur de dissipation (5), le radiateur de dissipation (5) étant monté dans une baignoire intérieure (11) ou une baignoire extérieure (12).

10. Convertisseur électrique (1) selon la revendication 9 dans lequel le radiateur de dissipation (5) comporte des ailettes (51) positionnées dans la baignoire intérieure (11) ou dans la baignoire extérieure (12).

11. Convertisseur électrique (1) selon l'une des revendications 9 à 10, dans lequel le dispositif de puissance (3-1 ;3-18) comporte des organes de verrouillage (7) configurés pour coopérer avec des organes de réception (15) formés dans le carter (10) de manière à maintenir le radiateur de dissipation (5) dans la baignoire intérieure (11) ou la baignoire extérieure (12).

12. Module électrique (M) comportant :
• une machine électrique (2), en particulier pour aéronef, comprenant un stator annulaire (21) et un rotor (22), et
• un convertisseur électrique (1) selon l'une des revendications 1 à 11, dont les dispositifs de puissance (3-1 ; 3-18) sont reliés au stator annulaire (21) de manière à alimenter la machine électrique (2).

13. Module électrique (M) selon la revendication 12, dans lequel, le convertisseur électrique (1) comportant un circuit de refroidissement (9), désigné ci-après premier circuit de refroidissement (9), la machine électrique (2) comportant un circuit de refroidissement, désigné ci-après deuxième circuit de refroidissement (9'), le premier circuit de refroidissement (9) et le deuxième circuit de refroidissement (9') sont alimentés en série en fluide de refroidissement (F).

14. Module électrique (M) selon la revendication 12, dans lequel, le convertisseur électrique (1) comportant un circuit de refroidissement (9), désigné ci-après premier circuit de refroidissement (9), la machine électrique (2) comportant un circuit de refroidissement, désigné ci-après deuxième circuit de refroidissement (9'), le premier circuit de refroidissement (9) et le deuxième circuit de refroidissement (9') sont alimentés en parallèle en fluide de refroidissement (F).

15. Procédé d'utilisation d'un module électrique (M), selon l'une des revendications 12 à 14, comprenant des étapes consistant à :
• Alimenter la machine électrique (2) par les dispositifs de puissance (3-1 ;3-18) du convertisseur électrique (1),
• Faire circuler un fluide de refroidissement (F) dans le circuit de refroidissement (9) du convertisseur électrique (1) de manière à refroidir lesdits dispositifs de puissance (3-1 ;3-18).

## Patentansprüche

1. Elektrischer Wandler (1) zur Versorgung einer elektrischen Maschine (2), insbesondere für Flugzeuge, die einen ringförmigen Stator (21) und einen Rotor (22) aufweist, wobei der elektrische Wandler (1) umfasst:
• eine Vielzahl von Leistungswechselrichtern (01-06), die jeweils eine Vielzahl von Leistungsvorrichtungen (3-1; 3-18) umfassen, die ausgelegt sind, um mit dem ringförmigen Stator (21) zur Versorgung der elektrischen Maschine (2) mit Strom verbunden zu sein,
• ein ringförmiges Gehäuse (10), das sich längs gemäß einer Achse X erstreckt und eine radial innere Fläche (S1) und eine radial äußere Fläche (S2) definiert, wobei das Gehäuse (10) eine Vielzahl von Kühlwannen aufweist, die in der radial inneren Fläche (S1) ausgebildet sind, bezeichnet als Innenwannen (11), und in der radial äußeren Fläche (S2), bezeichnet als Außenwannen (12),
• einen Kühlkreislauf (9), der ausgelegt ist, um jede Innenwanne (11) und jede Außenwanne (12) mit Kühlfluid (F) zu versorgen, und
• wobei die Leistungsvorrichtungen (3-1; 3-18) in den Innenwannen (11) und den Außenwannen (12) derart angebracht sind, dass eine Kühlung aller Leistungsvorrichtungen (3-1; 3-18) ermöglicht wird.

2. Elektrischer Wandler (1) nach Anspruch 1, wobei die Innenwannen (1) und/oder die Außenwannen (12) die gleiche Längsposition haben.

3. Elektrischer Wandler (1) nach einem der Ansprüche 1 und 2, wobei der elektrische Wandler (1) ebenso viele Innenwannen (11) wie Außenwannen (12) aufweist.

4. Elektrischer Wandler (1) nach einem der Ansprüche 1 bis 3, wobei die Innenwannen (11) und die Außenwannen (12) am Umfang des Gehäuses (10) abwechselnd angeordnet sind.

5. Elektrischer Wandler (1) nach einem der Ansprüche 1 bis 4, wobei die Innenwannen (11) und die Außenwannen (12) winklig am Umfang des Gehäuses (10) verteilt sind.

6. Elektrischer Wandler (1) nach einem der Ansprüche 1 bis 5, wobei der Kühlkreislauf (9) einen Einlass (9A) und einen Auslass (9B) aufweist, die diametral gegenüberliegen und durch mindestens zwei unabhängige, vorzugsweise diametral gegenüberliegende Kühlzweige (B1, B2) verbunden sind.

7. Elektrischer Wandler (1) nach einem der Ansprüche 1 bis 6, wobei der Kühlkreislauf (9) Kanäle (90) aufweist, die sich in der Dicke des Gehäuses (10) erstrecken und die Innenwannen (11) und die Außenwannen (12) verbinden.

8. Elektrischer Wandler (1) nach Anspruch 7, wobei zwei benachbarte Wannen (11, 12) durch eine Vielzahl unabhängiger Kanäle (90), vorzugsweise mehr als 10, verbunden sind.

9. Elektrischer Wandler (1) nach einem der Ansprüche 1 bis 8, wobei mindestens eine Leistungsvorrichtung (3-1; 3-18) ein Leistungsmodul (4) aufweist, das einem Ableitkörper (5) zugeordnet ist, wobei der Ableitkörper (5) in einer Innenwanne (11) oder einer Außenwanne (12) angebracht ist.

10. Elektrischer Wandler (1) nach Anspruch 9, wobei der Ableitkörper (5) in der Innenwanne (11) oder in der Außenwanne (12) angeordnete Rippen (51) aufweist.

11. Elektrischer Wandler (1) nach einem der Ansprüche 9 bis 10, wobei die Leistungsvorrichtung (3-1; 3-18) Verriegelungselemente (7) aufweist, die ausgelegt sind, um mit in dem Gehäuse (10) ausgebildeten Aufnahmeelementen (15) derart zusammenzuwirken, dass der Ableitkörper (5) in der Innenwanne (11) oder der Außenwanne (12) gehalten wird.

12. Elektrisches Modul (M), aufweisend:
• eine elektrische Maschine (2), insbesondere für Flugzeuge, die einen ringförmigen Stator (21) und einen Rotor (22) umfasst, und
• einen elektrischen Wandler (1) nach einem der Ansprüche 1 bis 11, dessen Leistungsvorrichtungen (3-1; 3-18) mit dem ringförmigen Stator (21) verbunden sind, um die elektrische Maschine (2) zu versorgen.

13. Elektrisches Modul (M) nach Anspruch 12, wobei, wenn der elektrische Wandler (1) einen Kühlkreislauf (9), nachfolgend als erster Kühlkreislauf (9) bezeichnet, aufweist, wenn die elektrische Maschine (2) einen Kühlkreislauf, nachfolgend als zweiter Kühlkreislauf (9') bezeichnet, aufweist, der erste Kühlkreislauf (9) und der zweite Kühlkreislauf (9') in Reihe mit Kühlfluid (F) versorgt werden.

14. Elektrisches Modul (M) nach Anspruch 12, wobei, wenn der elektrische Wandler (1) einen Kühlkreislauf (9), nachfolgend als erster Kühlkreislauf (9) bezeichnet, aufweist, wenn die elektrische Maschine (2) einen Kühlkreislauf, nachfolgend als zweiter Kühlkreislauf (9') bezeichnet, aufweist, der erste Kühlkreislauf (9) und der zweite Kühlkreislauf (9') parallel mit Kühlfluid (F) versorgt werden.

15. Verfahren zur Verwendung eines elektrischen Moduls (M) nach einem der Ansprüche 12 bis 14, das die folgenden Schritte umfasst:
• Versorgen der elektrischen Maschine (2) durch die Leistungsvorrichtungen (3-1; 3-18) des elektrischen Wandlers (1),
• Versetzen eines Kühlfluids (F) im Kühlkreislauf (9) des elektrischen Wandlers (1) derart in Zirkulation, dass die Leistungsvorrichtungen (3-1; 3-18) gekühlt werden.

## Claims

1. Electrical converter (1) configured to supply an electric machine (2), in particular for aircraft, comprising an annular stator (21) and a rotor (22), the electrical converter (1) comprising:
• a plurality of power inverters (01-06) each comprising a plurality of power devices (3-1; 3-18) configured to be connected to the annular stator (21) so as to supply the electric machine (2) with power,
• a casing (10), having an annular shape, extending longitudinally along an axis (X) and defining a radially inner surface (S1) and a radially outer surface (S2), the casing (10) comprising a plurality of cooling baths formed in the radially inner surface (S1), called inner baths (11), and in the radially outer surface (S2), called outer baths (12),
• a cooling circuit (9) configured to supply each inner bath (11) and each outer bath (12) with coolant (F), and
• the power devices (3-1; 3-18) being mounted in the inner baths (11) and in the outer baths (12) so as to allow cooling of all the power devices (3-1; 3-18).

2. Electrical converter (1) according to claim 1, wherein the inner baths (1) and/or the outer baths (12) have the same longitudinal position.

3. Electrical converter (1) according to one of claims 1 and 2, wherein the electrical converter (1) comprises as many inner baths (11) as outer baths (12).

4. Electrical converter (1) according to one of claims 1 to 3, wherein the inner baths (11) and the outer baths (12) are alternated at the periphery of the casing (10).

5. Electrical converter (1) according to one of claims 1 to 4, wherein the inner baths (11) and the outer baths (12) are angularly distributed at the periphery of the casing (10).

6. Electrical converter (1) according to one of claims 1 to 5, wherein the cooling circuit (9) comprises an inlet (9A) and an outlet (9B) that are diametrically opposite and connected by at least two independent cooling branches (B1, B2), preferably, diametrically opposite.

7. Electrical converter (1) according to one of claims 1 to 6, wherein the cooling circuit (9) comprises channels (90) extending in the thickness of the housing (10) and connecting the inner baths (11) and the outer baths (12).

8. Electrical converter (1) according to claim 7, wherein two adjacent baths (11, 12) are connected by a plurality of independent channels (90), preferably, more than 10.

9. Electrical converter (1) according to one of claims 1 to 8, wherein at least one power device (3-1; 3-18) comprises a power module (4) associated with a heat sink (5), the heat sink (5) being mounted in an inner bath (11) or an outer bath (12).

10. Electrical converter (1) according to claim 9, wherein the heat sink (5) comprises fins (51) positioned in the inner bath (11) or in the outer bath (12).

11. Electrical converter (1) according to one of claims 9 to 10, wherein the power device (3-1; 3-18) comprises locking members (7) configured to cooperate with receiving members (15) formed in the casing (10) so as to maintain the heat sink (5) in the inner bath (11) or the outer bath (12).

12. Electrical module (M) comprising:
• an electric machine (2), in particular for aircraft, comprising an annular stator (21) and a rotor (22), and
• an electrical converter (1) according to one of claims 1 to 11, the power devices (3-1; 3-18) of which are connected to the annular stator (21) so as to supply the electric machine (2) with power.

13. Electrical module (M) according to claim 12, wherein the electrical converter (1) comprising a cooling circuit (9), hereinafter referred to as the first cooling circuit (9), the electric machine (2) comprising a cooling circuit, hereinafter referred to as the second cooling circuit (9'), the first cooling circuit (9) and the second cooling circuit (9') are supplied in series with coolant (F).

14. Electrical module (M) according to claim 12, wherein the electrical converter (1) comprising a cooling circuit (9), hereinafter referred to as the first cooling circuit (9), the electric machine (2) comprising a cooling circuit, hereinafter referred to as the second cooling circuit (9'), the first cooling circuit (9) and the second cooling circuit (9') are supplied in parallel with coolant (F).

15. Method for using an electrical module (M) according to one of claims 12 to 14, comprising steps consisting of:
• Supplying the electric machine (2) via the power devices (3-1; 3-18) of the electrical converter (1),
• Circulating a coolant (F) in the cooling circuit (9) of the electrical converter (1) so as to cool said power devices (3-1; 3-18).
